Europäisches Patentamt

European Patent Office

Office européen des brevets

(11) Veröffentlichungsnummer: **0 191 938 B1**

# EUROPÄISCHE PATENTSCHRIFT

(45) Veröffentlichungstag der Patentschrift: **12.06.91**

(51) Int. Cl.⁵: **H03J 7/18**

(21) Anmeldenummer: **85116144.8**

(22) Anmeldetag: **18.12.85**

(54) **Verfahren zum störungsbedingten Umschalten von Rundfunksignalen gleichen Modulationsinhaltes.**

(30) Priorität: **19.02.85 DE 3505720**

(43) Veröffentlichungstag der Anmeldung:
**27.08.86 Patentblatt 86/35**

(45) Bekanntmachung des Hinweises auf die Patenterteilung:
**12.06.91 Patentblatt 91/24**

(84) Benannte Vertragsstaaten:
**CH DE FR IT LI**

(56) Entgegenhaltungen:
**EP-A- 0 091 067**
**DE-A- 3 131 292**
**DE-B- 1 013 717**

(73) Patentinhaber: **GRUNDIG E.M.V. Elektro-Mechanische Versuchsanstalt Max Grundig holländ. Stiftung & Co. KG.**
**Kurgartenstrasse 37**
**W-8510 Fürth/Bay.(DE)**

(72) Erfinder: **Glaab, Arnold, Dr.**
**Hermann-Löns-Strasse 16**
**W-8510 Fürth(DE)**

## Beschreibung

Die Erfindung betrifft ein Verfahren der im Oberbegriff des Anspruchs 1 angegebenen Art.

Bei einem derartigen aus der DE-A-32 12 615 bekannten Verfahren wird ein verzögert wiedergegebenes Rundfunksignal im Falle einer Störung in seiner Wiedergabeintensität allmählich ausgeblendet und gleichzeitig ein anderes, ungestörtes Signal gleichen Modulationsinhaltes eingeblendet. Durch ein solches Überblenden sollen Störungen, die durch den Umschaltvorgang selbst bedingt sind und zum Beispiel beim direkten Umschalten mittels eines gesteuerten Schalters aufgrund von Phasendifferenzen der beiden Rundfunksignale entstehen und als Knackgeräusche hörbar sind, vermieden werden.

Es wurde jedoch festgestellt, daß auch mit dem bekannten Verfahren kein störungsfreies Umschalten von Rundfunksignalen gleichen Modulationsinhaltes möglich ist. Wie bereits in der deutschen Patentschrift DE-A-32 12 615 ausgeführt ist, treten am Ort des Empfängers zwischen Rundfunksignalen gleichen Modulationsinhaltes und unterschiedlicher Herkunft aufgrund von Laufzeitunterschieden Phasenverschiebungen auf. Derartige Phasenverschiebungen sind insbesondere bei Empfängern, die sich in Fahrzeugen befinden, auch nicht konstant, da sich die relative Lage des Empfängers zu den verschiedenen Senderstandorten ständig ändert. Werden solche Signale, wie es bei dem bekannten Überblendverfahren der Fall ist, wenn das gestörte Rundfunksignal noch nicht völlig ausgeblendet, das ungestörte Rundfunksignal jedoch bereits eingeblendet ist, überlagert, dann ergeben sich erhebliche Störungen, die die Wiedergabequalität während des allmählichen Überblendvorganges stark beeinträchtigen. Je nach Phasendifferenz können sich beide Signale vollkommen auslöschen oder aber additiv ergänzen bzw. verstärken, was zu Amplitudenausfällen bzw. -schwankungen während des Überblendvorganges führt.

Der Erfindung liegt die Aufgabe zugrunde, ein Verfahren der im Oberbegriff des Anspruchs 1 angegebenen Art so weiterzubilden, daß phasenbedingte Störerscheinungen beim Umschalten von Rundfunksignalen gleichen Modulationsinhaltes vermieden werden. Außerdem soll das Verfahren gemäß der Erfindung die Möglichkeit bieten, den Umschaltvorgang zeitlich so zu komprimieren, daß er für das menschliche Gehör nicht mehr wahrnehmbar ist.

Diese Aufgabe wird gemäß der Erfindung durch die im Kennzeichen des Anspruchs 1 angegebenen Maßnahmen gelöst. Vorteilhafte Weiterbildungen der Erfindung sind in den Unteransprüchen gekennzeichnet.

Bei dem Verfahren gemäß der Erfindung wird in vorteilhafter Weise der Wiedergabepegel eines ersten Rundfunksignals beim Auftreten einer Störung in seiner Intensität mit einer ersten Zeitkonstanten ausgeblendet und unmittelbar anschließend der Wiedergabepegel eines zweiten Rundfunksignals mit einer zweiten Zeitkonstanten, die gleich der ersten sein kann, eingeblendet. Hierbei entstehen weder Knackgeräusche durch Phasensprünge, wie sie beim direkten Umschalten mittels eines Schalters auftreten, noch phasenbedingte Amplitudenstörungen, wie sie bei dem bekannten Überblendverfahren festzustellen sind. Um nur unbedingt notwendige Umschaltvorgänge auszulösen, werden bei dem Verfahren gemäß der Erfindung ausschließlich Störungen berücksichtigt, die zum einen eine vorgegebene relative Mindestgröße in Bezug auf das Nutzsignal aufweisen und damit das Nutz-/Störsignalverhältnis hörbar verschlechtern und zum anderen wenigstens eine vorgegebene Mindestdauer erreichen, ab welcher die Störungen durch das menschliche Gehör überhaupt erst wahrgenommen werden. Da eine derartige Auswertung der auftretenden Störung eine bestimmte Zeit in Anspruch nimmt, wird die Wiedergabe der Rundfunksignale gegenüber ihrem Empfang außer um die Umschaltzeit in vorteilhafter Weise noch mindestens um die Auswertezeit der Störung verzögert. Damit wird eine Wiedergabe der empfangsseitig auftretenden Störung mit Sicherheit unterbunden. Es ist weiterhin von Vorteil, die Zeitkonstanten für den Aus- und Einblendvorgang so klein zu wählen, daß der durch diese Vorgänge bedingte Amplitudeneinbruch vom menschlichen Gehör aufgrund von dessen Trägheit nicht wahrgenommen wird.

Eine bevorzugte Ausbildung des Verfahrens gemäß der Erfindung besteht darin, für die Auswertung und Beurteilung der Störung von FM-Signalen die insbesondere bei Mehrwegeempfangsstörungen auftretenden Störspektren im Basisband oberhalb von 57 kHz heranzuziehen. Eine andere bzw. zusätzliche Methode, Störungen durch Mehrwegeempfang oder Feldstärkeschwankungen auszuwerten, besteht in der Ermittlung der Amplitudenmodulation der FM-Signale am Feldstärkeausgang des Rundfunkempfängers.

Hierbei kann durch eine digitale Auswertung des Spektrums oberhalb von 57 kHz nach Größe und Häufigkeit der Amplitude und/oder eine digitale Auswertung der Amplitudenmodulation des Feldstärkesignals in ganz besonders einfacher Weise die Wirkung einer Störung bewertet und bei Überschreiten der vorgegebenen Grenzen (Größe und Dauer der Störung) ein Umschalten auf ein ungestörtes Rundfunksignal gleichen Modulationsinhaltes bewirkt werden.

In vorteilhafter Weise kann auch die Verzögerung der Wiedergabe der Rundfunksignale gegenüber ihrem Empfang auf digitalem Wege durchge-

führt werden.

daß die Rundfunksignale digital verzögert werden.

**Ansprüche**

1. Verfahren zum störungsbedingten Umschalten der Wiedergabe von einem gestörten Rundfunksignal auf ein ungestörtes Rundfunksignal gleichen Modulationsinhaltes, wobei die Wiedergabe der Rundfunksignale gegenüber ihrem Empfang mindestens um die Dauer des Umschaltvorganges verzögert wird, **dadurch gekennzeichnet,** daß jede Störung des wiederzugebenden Rundfunksignals nach ihrer relativen Größe zum Nutzsignal und ihrer Dauer ausgewertet wird, daß die Wiedergabe der Rundfunksignale gegenüber ihrem Empfang zusätzlich noch mindestens um die Auswertezeit der Störung verzögert wird, daß ein Umschaltbefehl ausgelöst wird, falls durch die Störung ein vorgegebenes Nutz/Störsignalverhältnis für eine vorgegebene Mindestdauer unterschritten wird, und daß infolge des Umschaltbefehls das gestörte Rundfunksignal mit einer ersten Zeitkonstanten klickfrei ausgeblendet und unmittelbar anschließend das ungestörte Rundfunksignal mit einer zweiten Zeitkonstanten, die ebenso wie die erste so klein gewählt wird, daß der durch Aus- und Einblendvorgang bedingte Amplitudeneinbruch vom menschlichen Gehör aufgrund von dessen Trägheit nicht wahrnehmbar ist, klickfrei eingeblendet wird.

2. Verfahren nach Anspruch 1, **dadurch gekennzeichnet,** daß beide Zeitkonstanten für den Aus- und Einblendvorgang gleich groß gewählt werden.

3. Verfahren nach Anspruch 1 oder 2, **dadurch gekennzeichnet,** daß bei FM-Rundfunksignalen zur Beurteilung ihrer Störung die Amplituden der Störspektren oberhalb einer Modulationsfrequenz von 57 kHz ausgewertet werden.

4. Verfahren nach einem oder mehreren der Ansprüche 1 bis 3, **dadurch gekennzeichnet,** daß bei FM-Rundfunksignalen zur Beurteilung ihrer Störung die Amplitudenmodulation des Feldstärkesignals ausgewertet wird.

5. Verfahren nach einem oder mehreren der Ansprüche 1 bis 4, **dadurch gekennzeichnet,** daß die Störung digital ausgewertet wird.

6. Verfahren nach einem oder mehreren der Ansprüche 1 bis 5, **dadurch gekennzeichnet,**

**Claims**

1. Method for the noise-related switching-over of the reproduction from a disturbed broadcast signal to an undisturbed broadcast signal with the same programme content, the reproduction of the broadcast signals being delayed at least by the duration of the switching-over process compared with their reception, characterised in that each disturbance of the broadcast signal to be reproduced is analyzed for its relative magnitude with respect to the useful signal and its duration, in that the reproduction of the broadcast signals, in comparison with their reception, is additionally also delayed by at least the time for analyzing the disturbance, in that a switch-over command is triggered if due to the disturbance a predetermined useful signal/disturbance-signal ratio is not reached for a predetermined minimum duration, and in that due to the switch-over command, the disturbed broadcast signal is gated out click-free with a first time constant and immediately thereafter the undisturbed broadcast signal is gated in click-free with a second time constant which, like the first one, is selected to be of such shortness that the dip in amplitude due to the gating-out and gating-in process is not perceptible by the human ear due to its inertia.

2. Method according to Claim 1, characterised in that both time constants for the gating-out and gating-in process are selected to be of identical magnitude.

3. Method according to Claim 1 or 2, characterised in that in the case of FM broadcast signals, the amplitudes of the disturbance spectra are analyzed above a modulation frequency of 57 kHz for assessing their disturbance.

4. Method according to one or more of Claims 1 to 3, characterised in that in the case of FM broadcast signals, the amplitude modulation of the field strength signal is analyzed for assessing their disturbance.

5. Method according to one or more of Claims 1 to 4, characterised in that the disturbance is digitally analyzed.

6. Method according to one or more of Claims 1 to 5, characterised in that the broadcast signals are digitally delayed.

## Revendications

1. Procédé pour réaliser la commutation, en cas de perturbations, de la reproduction depuis un signal radio perturbé à un signal radio non perturbé possédant le même contenu de modulation, la reproduction des signaux radio étant retardée, par rapport à leur réception, au moins de la durée de l'opération de commutation, caractérisé en ce qu'on évalue l'amplitude relative par rapport au signal utile et la durée de chaque perturbation du signal radio devant **être reproduit** qu'on retarde en outre la reproduction des signaux radio, par rapport à leur réception, au moins de la durée d'évaluation de la perturbation, qu'une instruction de commutation est déclenchée dans le cas ou du fait de la porturbation d'un rapport signal utile/bruit prédéterminé pour une durée minimale prédéterminée n'est pas atteint et que, sous l'effet de l'instruction de commutation, le signal radio pertubé est occulté sans claquement, avec une première constante de temps et que le signal radio non perturbé est aussitôt après introduit sans claquement avec une seconde constante de temps que l'on choisit aussi faible que la première pour que la réduction d'amplitude, conditionnée par les opérations d'occultation et d'insertion, ne puisse pas être détectée par l'oreille humaine, en raison de l'inertie de cette dernière.

2. Procédé selon la revendication 1, caractérisé en ce qu'on choisit une même valeur pour les deux constantes de temps pour l'opération d'occultation et l'opération d'insertion.

3. Procédé selon la revendication 1 ou 2, caractérisé en ce que dans le cas de signaux radio à modulation de fréquence, pour évaluer la perturbation de ces signaux, on évalue l'amplitude des spectres parasites au-dessus d'une fréquence de modulation de 57 kHz.

4. Procédé selon une ou plusieurs des revendications 1 à 3, caractérisé en ce que dans le cas de signaux radio à modulation de fréquence, pour évaluer leur perturbation, on évalue la modulation d'amplitude du signal de l'intensité de champ.

5. Procédé selon une ou plusieurs des revendications 1 à 4, caractérisé en ce qu'on réalise une évaluation numérique de la perturbation.

6. Procédé selon une ou plusieurs des revendications 1 à 5, caractérisé en ce qu'on retarde numériquement les signaux radio.